(19)

**Europäisches Patentamt**

**European Patent Office**

**Office européen des brevets**

(11) **EP 1 648 059 A2**

(12) **EUROPEAN PATENT APPLICATION**

(43) Date of publication:
**19.04.2006 Bulletin 2006/16**

(51) Int Cl.:
*H01S 5/14* (2006.01)          *H01S 3/109* (2006.01)

(21) Application number: **05256396.2**

(22) Date of filing: **14.10.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **14.10.2004 US 966309**

(71) Applicant: **Picarro Inc.**
**Sunnyvale, CA 94085 (US)**

(72) Inventors:
• **Paldus, Barbara**
**Sunnyvale, CA 94085-4708 (US)**

• **Richman, Bruce**
**Sunnyvale, CA 94085-4708 (US)**
• **Knippels, Guido**
**Sunnyvale, CA 94085-4708 (US)**
• **Rella, Chris**
**Sunnyvale, CA 94085-4708 (US)**

(74) Representative: **Leeming, John Gerard**
**J.A. Kemp & Co.,**
**14 South Square,**
**Gray's Inn**
**London WC1R 5JJ (GB)**

(54) **A semiconductor laser**

(57)     A doubled, external cavity laser comprises an external cavity pump laser section and an extra-cavity frequency doubling section, The pump laser section comprises an edge-emitting, semiconductor chip having:

i) an anti-reflection coating on the chip facet facing the cavity
ii) a low reflectivity coating on the output facet of the cavity,
iii) a wavelength selective element on the anti-reflection side of the chip for producing a single-mode output beam,
iv) at least one lens on the output side of the chip which operates to collimate the chip output beam and direct it to the frequency doubling section.

The doubling section comprises:

i) a second harmonic generating crystal consisting of gray track resistant PPKTP, stoichiometric PPLT, MgO doped stoichiometric PPLN, or MgO doped congruent PPLN,
ii) doubling optics configured such that the chip output beam makes from one up to four collinear passes through the doubling crystal, and the second harmonic generation achieved through multiple passes is constructive,
iii) beam shaping optics to create a collimated, frequency doubled output beam.

**FIGURE 2**

**Description**

This invention relates to doubled, external cavity semiconductor lasers emitting in the 300nm to 600nm wavelength range and incorporating specific, non-linear frequency doubling crystals. The lasers of the present invention are particularly useful for biophotonic applications.

The forces driving the development of new instrumentation for applications in biomedical research and in clinical diagnostics are closely related. First, there is the desire for new capabilities and improved performance. In the last 30 years entirely new and sizable industry segments have resulted from the development of instrumentation with new capabilities such as gene sequencing, flow cytometry, proteomics, and confocal microscopy. These instruments have significantly accelerated advances in immunology, oncology and drug discovery.

A second important driver is the need to continuously improve instrument economics. The initial cost, operating cost, reliability, size, measurement speed and ease of use of such instruments has a major influence on how widely deployed and utilized such instruments will be. As a result, the economics of an instrument can ultimately influence the rate at which new cures and drug treatments are discovered and the quality of healthcare available to the public, so that the capabilities and economics of instrumentation may be more important in the biomedical industry than in any other.

The use of lasers in biomedical instruments has been fundamental to the development of new instrument capabilities. Instruments to study cells, genes and proteins are all critically dependent on lasers for their function. These instruments include flow cytometers, DNA sequencers, array scanners, microplate readers, confocal microscopes and mass spectrometers. Therefore, it is not surprising that improvements in the performance and economics of these instruments is also influenced, and in some cases limited, by the performance and economics of their laser sources. As these instruments advance from basic research tools to diagnostic and drug discovery solutions, the instruments, and especially the lasers, are frequently required to simultaneously deliver both better performance and economics.

Many laser-based biomedical instruments were conceived around gas tube lasers (e.g., Argon ion lasers). The generally good optical performance characteristics of Argon ion lasers have been pivotal to their adoption and use in numerous commercial instruments. Specifically, Argon ion lasers provide a Gaussian $TEM_{00}$ beam ($M^2 < 1.1$) that is stable in wavelength (< 0.1 nm), beam pointing (<10 $\mu$rad/°C), and power (<2% variation) under a range of environmental conditions (4$\underline{o}$C to 40$\underline{o}$C, 0 to 90% humidity), at a competitive price. However, Argon ion lasers have significant limitations: size (5" x 6" x 12" for the laser head plus 5" x 6" x 11" for the power supply), weight (14 lbs for the head and 15 ibs for the power supply), power consumption (- 2.5 kW), and limited operational life (MTTF-5,000 hours). Moreover, Argon ion lasers are not precisely single mode, i.e., have imperfect side mode suppression.

In the past, Argon ion lasers were the only source of the blue (488 nm) and green (514 nm) light needed to induce the fluorescence upon which the operation of many diagnostic/analytical instruments depends. Argon ion lasers were only adequate as long as the bio-instruments in which they were used were confined to basic research applications. In today's drug discovery labs instrument utilization frequently comes closer to a production environment than to a research lab. This means instrument reliability has become increasingly critical. At the same time, researchers are looking for more capability from their instruments, which often means that more wavelengths and consequently more lasers are being incorporated into each instrument. As a result, laser size, power conmsumption and operating lifetime have become critical differentiators.

In flow cytometry, for example, efforts are underway to develop instruments suitable for point of care (POC) deployment, i.e. in doctors offices or mobile labs. Flow cytometers use lasers to analyze blood cells. By analyzing the way laser light is scattered by cells having fluorescent tags, blood cells can be counted and sorted by cell type and pathogenic condition. One motivation for deploying such instruments close to the point of care is to provide immediate results and minimize sample loss or mishandling. The speed and reliability of diagnosis can be improved by moving these instruments close to the patient. Another case for POC diagnostic instruments is in the battle against HIV and AIDS. One of the biggest challenges in places such as sub-Saharan Africa is to determine who is HIV positive. This frequently requires a blood test. Mobile labs with clinical diagnostic grade cytometers able to provide rapid on-site results, appear likely to be the only truly effective way to tackle this problem.

As instruments such as flow cytometers migrate from research labs to clinical settings, the importance of measurement accuracy and repeatability increases. In this case laser intensity noise over the lifetime of the laser is a key factor limiting the deployment and utilization of the instruments. Argon ion lasers are not capable of meeting new requirements for high reliability, small size, high operating efficiency and superior optical performance. For recent developments in this field see, for example, "Laser Focus World", August 2004, pp 69-74.

This need has driven efforts to find a replacement for Argon ion lasers by new solid-state laser platforms with enhanced features and performance to meet the evolving needs of the bio-instrument community. Bio-analytical instrumentation is a demanding application that requires a high performance solution. In comparison to an Argon ion laser, a typical 20 mW diode pumped, solid state laser (DPSS) emitting, for example, at 532 nm can produce an optical beam of similar quality and stability in 10% of the volume while consuming less than 5% of the power, plus having an in-service lifetime that is at least twice as long.

Because these characteristics are increasingly important in biomedical applications, a growing need is evolving for a solid-state alternative to existing lasers in the 300nm (near UV) to 600nm (orange) wavelength range. Specific wavelengths which are currently of particular importance in biophotonic analysis include 355, 360, 405, 430, 460, 473, 488, 506, 514, 532, 560 nm. There is especially a need for cyan (blue 488nm), green (532nm), and violet (405nm) lasers that do not compromise optical performance. To meet the new requirement of biomedical applications the new solid-state lasers will require good optical performance (laser intensity noise, wavelength stability and side mode suppression), reliability that is two to four times better than incumbent (e.g., Argon ion) technologies, a form factor that is one tenth the size (< 300 cm$^2$) and has one fiftieth the input power and heat dissipation in operation (< 30 W). Such performance demands constrain the available design space for such a solid state laser.

A lack of suitable crystal material has heretofore made especially the cyan (i.e.,blue 488 nm) wavelength unattainable using the laser designs typically employed to produce other visible light wavelengths such as green. These older laser designs start with a high power semiconductor laser that produces light in the near-infrared (808 nm) which is then used to pump a material (e.g., Neodymium Yttrium Aluminum Garnet) that transforms the light further into the infrared (1064 nm) which is then converted to visible (green 532nm) light by a frequency doubling crystal through a process known as second-harmonic generation (SHG).

The basic principles of SHG using periodically poled, non-linear crystals are well known. A recent treatise which provides an excellent summary is "Compact Blue Green Lasers" by W. R, Risk, T. R. Gosnell and A. V. Nurmikko, Cambridge University Press, 2003, ISBN 0-521-62318-9. See especially Chapters 2-5 and most especially pages 71- 90.

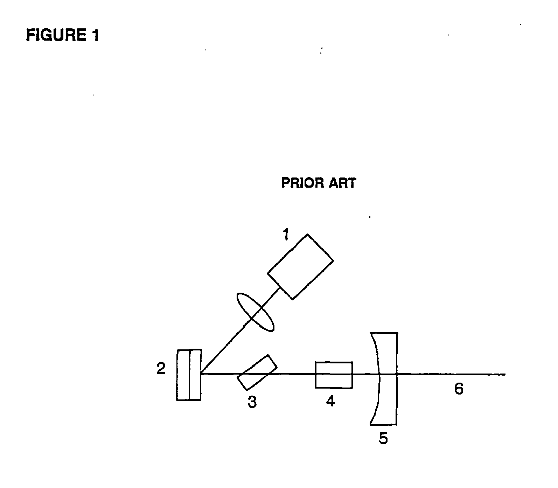

Despite the strong market demand for solid-state cyan, green and violet lasers, the technical hurdles have been daunting. Although SHG technology can be achieved utilizing a variety of nonlinear materials, their conversion efficiency remains limited: For example, using current technology the generation of 20mW of cyan (488nm) light typically requires several hundred milliwatts of 976 nm radiation. Moreover, because the acceptance bandwidth of most nonlinear materials is quite narrow (< 0.1 nm), the wavelength stability and line width of this high power pump laser become critical. A prior art architecture for generating cyan light, using a semiconductor pump laser, is shown in Figure 1, i.e., intracavity SHG using an optically pumped semiconductor laser (OPSL). OPSL based SHG was apparently first proposed by Mooradian in 1991 and the first commercial solid-state cyan laser was launched in 2001. OPSL technology, similar to the older solid-state laser technology, uses a 808 nm pump laser. The gain material is a semiconductor-based, vertical, external cavity surface emitting laser (VECSEL). In this geometry, the SHG crystal is Lithium Borate (LBO), and it is located inside the optical cavity. A wavelength selective element which is used to select a single longitudinal mode, is also located inside the same optical cavity. High finesse VECSEL cavities are generally used to achieve the large intracavity power required for efficient frequency doubling. The dichroic output mirror of the VECSEL then transmits the 488nm radiation generated inside the cavity. However, this architecture is both complex and expensive, owing to the heat sinking required for the VECSEL. Also, the yield of the VECSEL material itself is not high. Finally, the reliability of the product is limited by the lifetime of both the 808 nm pump laser and the VECSEL material.

Alternative intracavity designs have been proposed, where the VECSEL is electrically rather than optically pumped, e.g., the Novalux Protera laser. However, the output power demonstrated with this design using Potassium Niobate (KNO) as the doubling material, apparently does not exceed 15 mW. More recently, other prior art workers have reported a 40 mW intracavity SHG laser that used a periodically poled Potassium Titanyl Phosphate (PPKTP) doubling crystal. See, e.g., U S Patents Nos. 5,991,318; 6,097,742; and 6,167,068. However, the VECSEL architecture used creates an intracavity beam having a large divergence angle, i.e., an angle which is substantially larger than the acceptance angle of a periodically poled material, which perforce leads to poor conversion efficiency.

As already indicated, the requirements for the next generation biomedical devices such as flow cytometers dictate a low-cost 405, 488 or 532 nm laser with high reliability and improved optical performance (i.e. low noise). The low-cost requirement is not easily met with the current solid-state gain medium solution. These solutions typically require expensive optical pumping schemes, whereas in contrast semiconductor lasers can be mass-produced for little cost and can be electrically pumped. The challenge is how to make a low noise laser (both low intensity noise and stable wavelength). For this one needs to use an external cavity laser with a wavelength selective element since this is one of the few ways to make a single-longitudinal mode laser. This is required because if one has multiple longitudinal modes in the laser output, the phases of these different modes are not correlated and will cause the output to show mode partition noise. However, having a single-longitudinal mode laser is not sufficient since one still needs to ensure that the pump, whether electrical or optical, also has low noise.

Reliability is also an issue. Tremendous efforts have been made to develop a semiconductor laser for 980 nm telecom applications. These lasers require lifetimes of 20 years or longer, are deployed at the bottom of the ocean and have to cope with large temperature variations. This multi-billion dollar high-volume semiconductor VECSELs, therefore the reliability of these devices is much less developed. The size of the biophotonics market is currently not big enough to warrant a serious effort to enhance the reliability of these VECSEL devices to the same level as the telecom 980 pump lasers. VECSELs will not easily achieve the same reliability, and at best will obtain decent reliability only if additional reliability development is funded, thereby further increasing the ultimate price of a VECSEL-based product.

The invention will now be described with reference to the accompanying nonlimiting drawings.

Figure 1 shows a prior art architecture for a laser generating 488nm light by means of intracavity second harmonic generation using an optically pumped semiconductor. In Figure 1, No. 1 denotes an 808nm pump laser, No. 2 a 980nm VECSEL gain medium + a 980nm high reflector, No. 3 a wavelength selector, No. 4 an intracavity SHG crystal, No. 5 a 488nm output coupler + a 980nm high reflector and No. 6 a 488nm output beam."

Figure 2 is a schematic diagram of a doubled external-cavity semiconductor laser (DECSL) for providing single pass second harmonic generation (SHG) of light (especially blue, green or violet light) in accordance with the present invention.

Figures 3.1 and 3.2 are schematic diagrams of double and quadruple (four) pass DECSL configurations in accordance with the present invention.

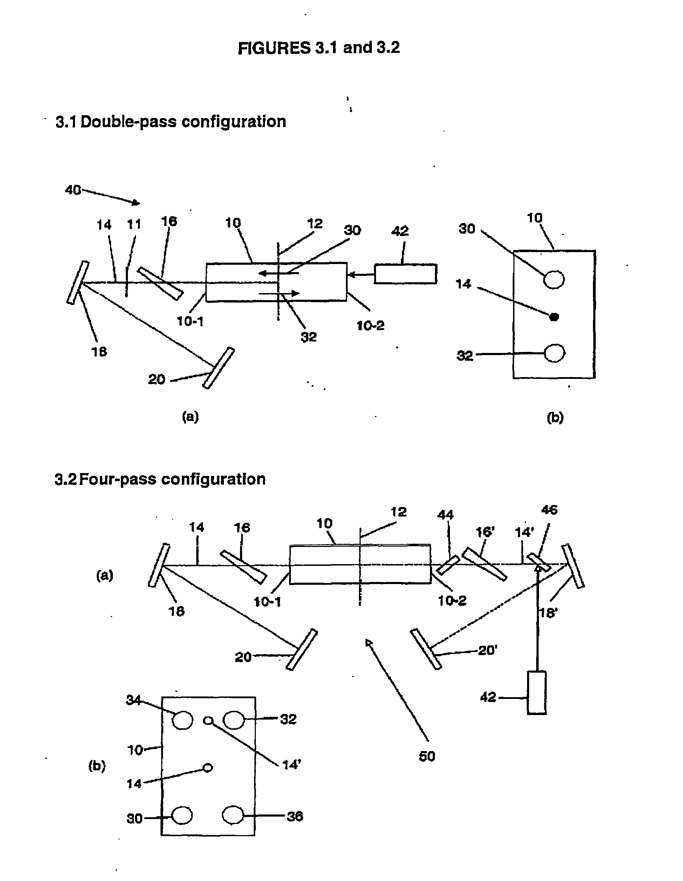

Figure 3.1.a is a schematic top view of a double pass embodiment of the invention.

Figure 3.1.b is a schematic end view of a nonlinear medium in a double pass embodiment of the invention.

Figure 3.2.a is a schematic top view of a quadruple pass embodiment of the invention.

Figure 3.2.b is a schematic end view of a nonlinear medium in a quadruple pass embodiment of the invention.

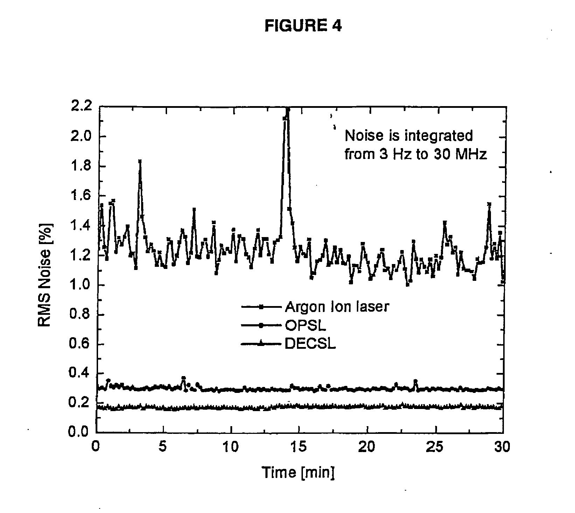

Figure 4 compares the optical noise results achieved using a DECSL laser with a gray track resistant PPKTP frequency doubling crystal in accordance with the present invention with results achieved using an Argon ion laser and an OPSL laser.

We have identified a particular type of laser configuration, namely, a doubled external cavity semiconductor laser (DECSL) which, when utilized in conjunction with a specific group of nonlinear optical materials to provide frequency doubling, (second harmonic generation) demonstrates the requisite performance, reliability and cost needed to provide a suitable laser which emits light at selected wavelengths in the 300 to 600nm range. Achieving the requisite performance requires a unique combination of components for several reasons:

i) using single-pass SHG may not allow one to achieve the required power level for all applications,
ii) when power requirements dictate the use of a double pass or quadruple pass architecture, achieving a reliable laser design that does not suffer from optical feedback is difficult. Our design provides two layers of protection to the DECSL laser (the component that suffers from feedback).

1. All the optical surfaces on which 976 nm radiation is incident are designed in such a way that the reflected light does not reflect back towards the pump laser.
2. The output consists of only one wavelength radiation, e.g., 488 nm. when the pump beam wavelength is 976nm. Even if all the output light were directed back into the laser it will not disturb the DECSL.

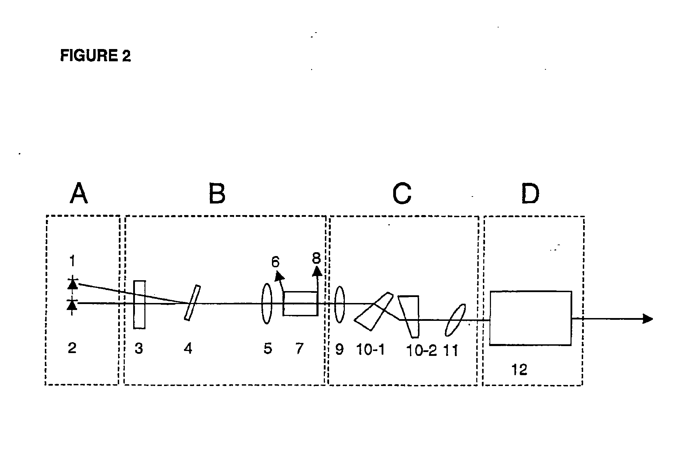

Note that although exact numbers are given (e.g., 488nm and 976nm) for wavelength, in actual practice the laser wavelength, whether before or after frequency doubling, can vary by as much as $\pm$ one nanometer.
As indicated, wavelengths in the 300 to 600nm range are particularly suitable for biophotonic applications. Our novel laser design combines recent advances in laser diode technology with advanced, periodically poled, nonlinear optical materials that offer significantly enhanced frequency (wavelength) conversion efficiency, thereby enabling the resulting product to uniquely meet the stringent power, size and other performance constraints of biophotonic applications. In addition, our unique optical architecture simplifies monitoring and control of the relevant optical parameters to thereby enable delivery of enhanced performance and reliability. A DECSL laser suitable for biomedical applications producing output light in the 300 to 600 nm wavelength range in accordance with the present invention is shown in Figure 2.
The laser comprises a doubled, external cavity laser comprising an external cavity pump laser section, (B) monitor optics (Section A) to control the external cavity laser, beam shaping optics to provide efficient second-harmonic generation using one, two or four passes through the extra-cavity frequency doubling section.
The pump laser section comprises an edge-emitting, semiconductor chip having:

i) an anti-reflection coating on the chip facet facing the cavity

ii) a low reflectivity coating on the output facet of the cavity,
iii) a lens, a wavelength selector and a reflective element on the anti-reflection side of the chip for producing a single-mode output beam,

In Section A there is shown two monitors that measure the transmitted beam through the end mirror and the reflected beam from the wavelength selective element. Combining the signals of these two monitors allows accurate control over the wavelength of the external cavity pump laser Section C includes beam shaping optics that produce an optical beam with minimal ellipticity and minimal astigmatism. A first lens collimates the divergent output of the edge emitter chip but produces an optical beam that has some residual astigmatism and ellipticity. The anamorphic prism pair provides (adjustable) magnification that is different in the vertical and horizontal planes. This way a circular beam, or a beam of selectable ellipticity, is produced. A tilted lens is suitably used to produce a focused beam into the second harmonic crystal that is free of astigmatism, or if preferred, with a selectable astigmatism.

The frequency doubling section (Section D) comprises:

i) a second harmonic generating crystal, selected from the group consisting of gray track resistant PPKTP, stoichiometric PPLT, and MgO doped congruent or stoichiometric PPLN,
ii) doubling optics configured such that the light path through the doubling crystal makes from one up to four collinear passes, and in the case of more than one pass, such that the second harmonic generation achieved through multiple passes is constructive,
iii) beam shaping optics to create a collimated, frequency doubled output beam.

For example, to generate 488 nm light, a DECSL in accordance with the present invention would use a 976 nm semiconductor gain medium inside an external cavity containing a wavelength selective element such as a narrow band transmission filter, which causes the laser chip to emit only a single longitudinal mode. The radiation from the external cavity laser is doubled by the external SHG crystal to generate 488nm light. The control system for the laser is robust, because the laser gain and the SHG, both nonlinear phenomena, are controlled independently. This independent control leads to greater amplitude stability and lower noise when compared to OPSL or other intracavity frequency conversion approaches. In comparison with all prior art designs, our laser provides a signal of very stable amplitude and low noise which provides a greatly reduced tendency to cause false positive or negative results in biophotonic applications. However, because there is no intracavity enhancement to increase the available pump power, our design requires specific, high conversion efficiency nonlinear optical materials.

Because nonlinear optical crystals are limited in size, especially in length, owing to manufacturability constraints, in order to achieve higher output powers beyond those available by simply passing the light one time through the crystal, multipass schemes may be required in certain high power applications. When implemented correctly, the output power increases as the square of the number of passes through the crystal. An optimized, multi-pass frequency doubling design is described in copending, commonly assigned U.S. Patent Application S.N. 10/910,121, filed 08/03/2004, the disclosure of which is incorporated herein by this reference.

If one considers typical biophotonics applications, the amount of light required ranges from about 5 mW for imaging applications up to about 100 mW for applications such as those involving high throughput and multiplexed flow cells. This regime is often referred to as the "low power" regime (LPR) for solid-state lasers (as opposed to the medium power regime which typically encompasses about 200 mW to 1 W, and the high power regime, which is typically 2W to 10W). In the present invention, we address only the LPR for biophotonics applications. Biophotonics instruments for which the frequency doubling lasers of the present invention are particularly suitable include flow cytometers, DNA and RNA sequencers, and microarray, microplate imagers and confocal microscopes..

If one considers the DECSL architecture of the present invention, a typical external cavity pump laser at e.g., 976 nm will be able to emit about 500 mW to 700 mW over its expected lifetime. For these output powers, the DECSL lifetime is consistent with the lifetime of most biophotonics instruments, namely about 20,000 hours of operation over a 5 to 7 year period. Such a laser should revolutionize the biophotonics instrument marketplace, because such lasers will no longer need to be replaced either every year (argon ion lasers) or at least every two years (OPSL technology).

However, a specific nonlinear optical material for the DECSL must be provided that can meet this service life requirement. For example, Lithium Borate (LBO) is a known SHG material, and it is used in numerous laser products today. It does, however, have certain critical shortcomings as shown in Table 1 (e.g., low SHG power). Likewise, Potassium Niobate (KNO) does not demonstrate adequate reliability and can suffer catastrophic damage from shock and/or low temperatures. Undoped Lithium Niobate (PPLN) crystals, whether congruent or stoichiometric, suffer from photorefractive damage, which significantly limits their lifetimes. Periodically-poled Potassium Titanyl Phosphate (PPKTP) is also prone to develop photorefractive damage (grey tracking), which, of course, significantly limits its usefulness. However, we have found that PPKTP can be made grey-track resistant by annealing it in accordance with the teaching of copending, commonly assigned U.S. Patent Application 10/910,045, filed August 3, 2004, the disclosure of which is incorporated herein by this reference. Thus, we have identified the following non-linear frequency doubling materials as being uniquely capable of satisfying the power and lifetime service requirements of a laser suitable for biophotonic or other demanding applications:

MgO doped (3% to 5%) Congruent PPLN (Co PPLN)

MgO doped (0.2-1.0%) Stoichiometric PPLN (St PPLN)

Stoichiometric PPLT (StPPLT)

Grey-track resistant PPKTP (GTR PPKTP)

The conversion efficiencies of the above-indicated, non-linear optical materials which we have found to have acceptable lifetimes, conversion efficiencies and robustness for biophotonics applications are given in Table 1, which also shows the material properties of some other unsuitable, prior art nonlinear optical materials (LBO and KNO). The SHG power shown assumes a crystal length of 10 mm. The Max. length indicated is the maximum currently available crystal length, which is usually determined by boule growth capability.

**TABLE 1**

| Material | $d_{eff}$ [pm/V] | Refractive index | Max Length [mm] | SHG Eff. [%/W/cm] | SHG power [mW] |
|---|---|---|---|---|---|
| LBO | ~0.8 | 1.6 | 10 | 0.014 | 0.04 |
| KNO | 11.9 | 2.2 | 10 | 1.7 | 4 |
| GTR PPKTP | 13 | 1.8 | 30 | 3 | 8 |
| MgO doped Co PPLN | 19 | 2.2 | 30 | 3.4 | 9 |
| St PPLT | 9 | 2.2 | 30 | 1.0 | 2.4 |

For a 500 mW 976 nm pump laser in a DECSL architecture, LBO does not produce sufficient second harmonic generation (SHG) power to meet the power requirements of biophotonics applications. KNO, although it might be able to meet the power requirements, does not demonstrate adequate reliability. Conventional PPKTP. is prone to photorefractive damage although its initial optical properties would not differ materially from GTR PPKTP. Likewise, the optical properties of MgO doped stoichiometric PPLN are not significantly different from those of the MgO doped congruent material shown in Table 1. As already indicated, we have identified certain particular nonlinear crystals which have both sufficient robustness and produce sufficient single-pass power (and multi-pass power where still higher power is required) to be suitable for use in a DECSL architecture for biophotonic applications. As indicated, we have identified the crystals having any of the following compositions as being uniquely suitable:
i) gray-track resistant PPKTP, ii) MgO doped congruent or stoichiometric PPLN and iii) stoichiometric PPLT. It should be particularly noted that although MgO doping to inhibit photorefractive damage is advantageous for both stoichiometric and congruent PPLN, the preferred doping levels differ. We have found that preferred MgO doping levels for congruent PPLN ranges from about 1-3%, while for stoichiometric PPLN a preferred range is from about 0.2 to 1.0%. Since SHG is proportional to crystal length, and is also proportional to the square of the number of passes (N) in a multi-pass configuration, the applicability of each material to biophotonic applications can now be assessed. Table 2 shows the potential space requirements for each of the crystal materials of the present invention for the three most common output powers required in biophotonics: 10 mW, 20 mW and 100 mW. Other commonly desired output powers are 30 mW, 40 mW and 75 mW. Table 2 also shows the design parameters for periodically poled materials for the three most common output powers. L is crystal length and N is the number of passes which would be used in a multipass DECSL design to achieve the indicated power output.

**TABLE 2**

| Material | 10 mW | | 20 mW | | 100 mW | |
|---|---|---|---|---|---|---|
| | L (mm) | N | L (mm) | N | L (mm) | N |
| GTR PPKTP | 12 | 1 | 12 | 2 | 12 | 4 |
| MgO doped congruent or stoichiometric PPLN | 11 | 1 | 11 | 2 | 11 | 4 |

Table continued

| Material | 10 mW | | 20 mW | | 100 mW | |
|---|---|---|---|---|---|---|
| | L (mm) | N | L (mm) | N | L (mm) | N |
| | | | 22 | 1 | 25 | 2 |
| St PPLT | 12 | 2 | 25 | 2 | 25 | 4 |

The configuration of a single, two and four pass DECSL are shown schematically in Figures 2, 3.1 and 3.2. A four pass DECSL is considered to be the practical limit of manufacturability. As is clear from Table 2, a four pass architecture is sufficient to achieve the highest normally required output power (100mW) for biophotonics applications.

Figure 2 shows a single pass frequency doubled laser design in accordance with the present invention. The sections of the laser are shown as follows:

    A. Monitor optics for the external cavity laser
    B. External cavity laser
    C. Beam shaping optics
    D. SHG section

The components present in each section are more particularly identified as follows:

    1. reflection monitor
    2. transmission monitor
    3. 980 nm high reflector
    4. wavelength selector
    5. external cavity collimation lens
    6. anti-reflection coated 980 nm gain chip facet
    7. 980 nm gain chip
    8. low-reflectivity coated 980 nm gain chip facet
    9. collimation lens
    10. anamorphic prism pair
    11. tilted focusing lens
    12. second-harmonic generating crystal

Section A does not form part of the current invention and contains known prior art components and is shown only for purpose of clarity and completeness. In Section B there is present a 980 mm gain chip 7 with anti-reflection and low reflectivity coatings 6 and 8, respectively, collimation lens 5, wavelength selector 4 and high reflection mirror 3. Light emanating from face 8 of gain clip 7 passes through collimating lens 9 in Section C through prism pair 10-1 and 10-2 and then into focusing lens 11 and then into second harmonic generation Section D where it is frequency doubled by a SHG crystal of the type described herein.

After frequency doubling the light passes out of the right side of Section D, as shown, for input into a flow cytometer or other medical device.

Because nonlinear optical crystals are limited in size, especially in length, owing to manufacturability constraints, in order to achieve higher output powers beyond those available by simply passing the light one time through the crystal, multipass schemes may be required in certain high power applications. When implemented correctly, the output power increases as the square of the number of passes through the crystal. An optimized, multi-pass frequency doubling design is described in previously referenced U.S. Patent Application S.N. 10/910,121, filed 08/03/2004.

Figure 3.1a is a schematic top view of a preferred embodiment of a double pass frequency doubling apparatus 40, in accordance with the present invention, while Figure 3.1 b is a schematic end view of a nonlinear medium 10 within apparatus 40. To appreciate the operation of apparatus 40, it is helpful to consider the beam paths through apparatus 40 before discussing the design of apparatus 40 in detail. A pump beam provided by a pump source (chip) 42 is received by a face 10-2 of nonlinear medium 10, and is transmitted along a beam path 30 through nonlinear medium 10. A second harmonic beam, with frequency twice the pump frequency, is generated within nonlinear medium 10, and is also transmitted along beam path 30 through nonlinear medium 10. The pump and second harmonic beams are emitted from face 10-1 of nonlinear medium 10, and are received by a phasor 16. The beams are transmitted through phasor 16 and are received by a mirror 18. The pump and second harmonic beams are then reflected by mirror 18 and are received by a mirror 20. Both beams are reflected by mirror 20, reflected again from mirror 18, and received by face 10-1 of nonlinear medium 10. The second pass pump and second harmonic beams are transmitted along a beam path 32 through nonlinear medium 10, and are emitted from face 10-2 of nonlinear medium 10.

Beam paths 30 and 32 through nonlinear medium 10 are preferably parallel to and spaced apart from each other; as indicated. This can be accomplished by choosing mirrors 18 and 20 such that they act as an inverting telescope to re-image a reference plane 12 located at the center of nonlinear medium 10 onto itself with negative unity magnification. Axis 14 is the axis of the telescope formed by mirrors 18 and 20, and is substantially centered within nonlinear medium 10. Thus, beam path 32 is the image of beam path 30 formed by the inverting telescope, and separation of beam paths 30 and 32 is obtained by offsetting beam path 30 from axis 14 as indicated in Figure 3.1 b. This separation of the second pass (beam path 32) from the first pass (beam path 30) is advantageous, since no additional optical elements are required to separate the second pass beams from the first pass beams.

The nonlinear medium 10 can be any of the materials already described herein as being suitable for the practice of the present invention. In some cases, it is desirable to avoid reflection of the pump beam back into the pump source; and in these cases, nonlinear medium 10 (or face 10-2 of nonlinear medium 10) can be slightly tilted (on the order of 0.5 degree to 1 degree) so that the pump beam is not exactly normally incident on face 10-2 of nonlinear medium 10. This ensures that the pump beam reflected from face 10-2 of nonlinear medium 10 does not couple back into the pump source. Preferably, faces 10-1 and 10-2 of nonlinear medium 10 are anti-reflection coated to provide a low reflectivity (i.e. reflectivity < 1 percent, more preferably < 0.5 percent) at both the pump frequency (or wavelength) and second harmonic frequency (or wavelength) to reduce loss in apparatus 40.

The purpose of phasor 16, which is an optional component, is to adjust the relative phase of the pump and second harmonic beams as the beams enter nonlinear medium 10 for a second or subsequent pass (i.e., beam path 32) so that the second pass contributes constructively to the second harmonic beam already present from the first pass. Phasor 16 is fabricated as a wedged plate of a dispersive optical material, i.e., a material which has a different index of refraction at the pump frequency and second harmonic frequency, where the wedge angle between the phasor surfaces is roughly on the order of 0.1 degree to 1 degree. Because phasor 16 is a wedged plate, the amount of dispersive material it introduces into the beam path is variable by translating the phasor perpendicular to the beams. For example, consider doubling of 976 nm radiation to 488 nm. A suitable material for phasor 16 is the commercial glass BK7, which has $n_\omega = 1.508$ and $n_{2\omega} = 1.522$ at these wavelengths, respectively. The coherence length of BK7 in this example is $L_c = 17.4$ $\mu$m. Since the beam makes a double pass through phasor 16, a full $2\pi$ adjustment of the relative phases of pump and second harmonic beams is obtained by varying the phasor thickness seen by the beams by $L_c = 17.4$ $\mu$m. Phasor 16 is preferably inserted into assembly 40 so that both pump and second harmonic beams are incident on phasor 16 at or near Brewster's angle and have p polarization (i.e., electric field vector lying in the plane of incidence of a phasor surface), to reduce reflection losses from the surfaces of phasor 16. Alternatively, phasor 16 may have an antireflection coating on its optical surfaces so that the phasor can be used at angles other than Brewster's angle without introducing substantial reflection losses.

Mirror 18 is a concave mirror with a radius of curvature R. Mirror 20 is a flat mirror which is separated from mirror 18 by a length L which is substantially equal to the focal length f = R/2 of mirror 18. Mirrors 18 and 20 are highly reflective (with reflectivity preferably greater than 99.5 percent) at both the pump and second harmonic frequencies. Mirrors 18 and 20 together form a telescope subassembly having an ABCD matrix (for both the pump and second harmonic beams) with A = -1, C = 0 and D = -1, with respect to an input and output reference plane 11 located between mirror 18 and phasor 16. The ABCD matrix describes the geometrical imaging properties of an optical system as follows:

$$\begin{pmatrix} y \\ y' \end{pmatrix} = \begin{pmatrix} A & B \\ C & D \end{pmatrix} \begin{pmatrix} x \\ x' \end{pmatrix} . \tag{1}$$

where x and x' are the position and slope, respectively, of an input ray relative to the optical axis of the system (i.e., axis 14 on Figure 3.1 a) at the input reference plane of the optical system, and y and y' are the position and slope, respectively, of the corresponding output ray at the output reference plane of the optical system. For optical systems which retro-reflect a beam, it is frequently convenient to select the same plane (e.g., reference plane 11) as the input reference plane and as the output reference plane.

Mirror 18 is preferably positioned such that the diffractive distance between reference plane 12 at the center of nonlinear medium 10 and mirror 18 is substantially equal to the focal length of mirror 18. The diffractive distance between two points separated by regions of length $L_i$ and index $n_i$ is $\Sigma L_i/n_i$. With this relative positioning of mirror 18 and nonlinear medium 10, reference plane 12 is re-imaged onto itself (with -1 magnification, i.e., inversion) by the telescope subassembly. This ensures that optimal focusing is preserved from one pass to the next. That is, if the first pass pump beam is optimally focused through nonlinear medium 10, (i.e., it has a beam waist of the appropriate size at reference plane 12 at the center of nonlinear medium 10), the second pass pump beam will also be optimally focused through nonlinear medium 10.

Although the primary purpose of the telescope subassembly is to couple the pump and second harmonic beams emitted from nonlinear medium 10 after the first pass back into nonlinear medium 10 for a second pass, the above properties of the ABCD matrix of the telescope subassembly have additional advantageous consequences.

The condition C = 0 ensures that the output ray slope depends only on the input ray slope (i.e., it does not depend on input ray position). Therefore, two rays which are parallel at the input of an optical system with C = 0 will be parallel at the output of that system. Optical systems with C = 0 are telescopes. For multipass SHG, the preservation of parallelism provided by a telescope is especially valuable, because the parallelism of the pump beam with the second harmonic beam on the first pass is preserved in the second pass, which significantly simplifies alignment. In apparatus 40, if C = 0 at reference plane 11, C is also 0 at reference plane 12, since there are no focusing elements between reference plane 11 and reference plane 12. Thus, if the first pass pump and second harmonic beams are parallel within nonlinear medium 10, then the second pass pump and second harmonic beams will also be parallel within nonlinear medium 10.

The condition D = -1 ensures that the first pass and second pass ray slopes of the pump beam (and the first pass and second pass ray slopes of the second harmonic beam) are identical between phasor 16 and mirror 18. The sign change of the ray slope from D = -1 is cancelled out by the sign change due to the reversal of the optical axis. This equality of ray slopes also extends into nonlinear medium 10, since there are no focusing elements between mirror 18 and nonlinear medium 10, so the second pass pump beam is parallel to the first pass pump beam within nonlinear medium 10, and the second pass second harmonic beam is parallel to the first pass second harmonic beam within nonlinear medium 10. Parallelism between first and second passes is advantageous because phase-matching typically has a narrow angular acceptance. If the first and second passes go through nonlinear medium 10 at significantly different angles, it may be impossible to efficiently phase-match both passes simultaneously.

The preservation of beam parallelism between first and second passes, as well as between the pump and second harmonic beams, also ensures that the linearly varying thickness of phasor 16 across the beams is cancelled in a double pass through phasor 16. In other words, the relative phase shift imparted to the second harmonic beam relative to the pump beam by a double pass through phasor 16 does not vary from point to point within the beams. Similarly, if nonlinear medium 10 has a linearly varying thickness from point to point within the beams (e.g. if face 10-1 is tilted with respect to the beams and face 10-2 is not tilted), the effect due to this variable thickness is cancelled in a double pass.

The arrangement of mirror 18 and mirror 20 shown in Figure 3.1 is a preferred telescope subassembly, since mirror 18 has the same focal length at both the pump and second harmonic frequencies. Other telescope subassemblies with A = -1, C = 0 and D = -1 (at both pump and second harmonic wavelengths) are also suitable for practicing the invention. In all cases it is preferred to position the telescope subassembly relative to nonlinear medium10 such that reference plane 12 at the center of nonlinear medium 10 is substantially re-imaged onto itself with -1 magnification, in order to preserve optimal focusing from one pass to the next.

Although the telescope subassembly with A = -1, C = 0 and D =-1 ensures beam parallelism within nonlinear medium 10, beam collinearity within nonlinear medium 10 is not ensured by the telescope subassembly. In other words, it is possible for the second pass second harmonic beam axis to be laterally separated from the second pass pump beam axis, even though the pump and second harmonic beam axes are collinear on the first pass. Two sources of this undesirable beam offset are the dispersion of phasor 16 and the dispersion of nonlinear medium 10 (if the beams intersect face 10-1 of nonlinear medium 10 at a non-normal angle of incidence). The beam offset is affected by the wedge angle of phasor 16, the nominal thickness of phasor 16, the length of nonlinear medium 10 (assuming the design is constrained to re-image reference plane 12 onto itself with -1 magnification), the angle of incidence on face 10-1 of nonlinear medium 10, and the distance between phasor 16 and nonlinear medium 10. Since varying these parameters changes the beam offset without affecting the parallelism preserving property of the telescope subassembly, the beam offset can be eliminated by design.

An additional consideration in a detailed design is astigmatism compensation, because phasor 16 and mirror 18 both cause astigmatism. The relevant parameters are the thickness, incidence angle and wedge angle of phasor 16, and the focal length and incidence angle of mirror 18. Again, these parameters offer enough flexibility to eliminate the net astigmatism of apparatus 40 by design (i.e., by ensuring that the astigmatism of phasor 16 compensates for the astigmatism of mirror 18, and conversely). In addition, there are enough parameters to eliminate astigmatism and to preserve collinearity simultaneously. It is desirable to ensure that apparatus 40 has no net astigmatism, to maximize conversion efficiency and to provide a non-astigmatic second harmonic beam after the second pass. It is also possible to eliminate astigmatism from apparatus 40 by adding one or more optical elements to apparatus 40 in accordance with known principles of telescope astigmatism compensation.

Figure 3.2 is a schematic top view of a four pass frequency doubling apparatus 50, in accordance with the present invention, while Figure 3.2b is a schematic end view of nonlinear medium 10 within apparatus 50. To appreciate the operation of apparatus 50, it is helpful to consider the beam paths through apparatus 50 before discussing the design of apparatus 50 in detail. A pump beam is received by face 10-2 of nonlinear medium 10, and is transmitted along beam path 30 through nonlinear medium 10. A second harmonic beam, with frequency twice the pump frequency, is generated within nonlinear medium 10, and is also transmitted along beam path 30 through nonlinear medium 10. The pump and second harmonic beams are emitted from face 10-1 of nonlinear medium 10, and are received by phasor 16. The beams are transmitted through phasor 16 and are received by mirror 18. The pump and second harmonic beams are reflected by mirror 18 and are received by mirror 20. Both beams are reflected by mirror 20, reflected again from mirror 18, transmitted again through phasor 16, and received by face 10-1 of nonlinear medium 10. The pump and second harmonic beams are transmitted in a second pass along beam path 32 through nonlinear medium 10, and are emitted from face 10-2 of nonlinear medium 10.

These two emitted beams are received by a phasor 16', transmitted through phasor 16', received by a mirror 18', reflected from mirror 18' and received by a mirror 20'. After reflection from mirror 20', the pump and second harmonic beams are reflected again from mirror 18', transmitted again through phasor 16', and received by face 10-2 of nonlinear medium 10. The pump and second harmonic beam are transmitted in a third pass along beam path 34 through nonlinear medium 10, and are emitted from face 10-1 of nonlinear medium 10.

These two emitted beams are received by phasor 16, transmitted through phasor 16, received by mirror 18, reflected from mirror 18, and received by mirror 20. After reflection from mirror 20, the pump and second harmonic beams are reflected again from mirror 18, transmitted again through phasor 16, and received by face 10-1 of nonlinear medium 10. The pump and second harmonic beams are transmitted in a fourth pass along beam path 36 through nonlinear medium 10, and are emitted from face 10-2 of nonlinear medium 10.

Beam paths 30, 32, 34 and 36 through nonlinear medium 10 are separated from each other, as indicated on Figure 3.2b. This is accomplished by choosing mirrors 18 and 20 such that they act as a first inverting telescope to re-image reference plane 12 located at the center of nonlinear medium 10 onto itself with negative unity magnification. Axis 14, which is the axis of the telescope formed by mirrors 18 and 20, is substantially centered within nonlinear medium 10 as indicated on Figure 3.2b. Thus, beam path 32 is the image of beam path 30 formed by the inverting telescope, and separation of beam paths 30 and 32 is obtained by offsetting beam path 30 from axis 14 as indicated on Figure 3.2b. Mirrors 18' and 20' are also selected such that they act as an inverting telescope to re-image reference plane 12 onto itself with negative unity magnification. Axis 14' is the axis of the telescope formed by mirrors 18' and 20', and is offset from axis 14 as indicated on Figure 3.2b. Thus, third pass beam path 34 is the image of second pass beam path 32 formed by this second inverting telescope. Similarly, fourth pass beam path 36 is the image of third pass beam path 34 formed by the first inverting telescope with axis 14. Therefore, all four passes follow distinct paths through nonlinear medium 10, where second pass beam path 32 is the inversion of first pass beam path 30 about axis 14, third pass beam path 34 is the inversion of second pass beam path 32 about axis 14', and fourth pass beam path 36 is the inversion of third pass beam path 34 about axis 14.

Since the four passes in apparatus 50 do not overlap, no beam splitters (which introduce undesirable loss) are required to couple the pump beam into apparatus 50, or to couple the second harmonic beam out of apparatus 50. A preferred method for coupling the pump beam into apparatus 50 is to position a pump turning mirror 46 within apparatus 50 so that a pump beam provided by pump source 42 is reflected to follow beam path 30 through nonlinear medium 10, and such that pump turning mirror 46 does not block the second pass beams following beam path 32 through nonlinear medium 10 or the third pass beams following beam path 34 through nonlinear medium 10.

A preferred method for coupling the second harmonic beam out of apparatus 50 is to position a second harmonic turning mirror 44 within apparatus 50 so that the fourth pass second harmonic beam following beam path 36 through nonlinear medium 10 is reflected out of apparatus 50, and such that second harmonic turning mirror 44 does not block the first pass pump beam following beam path 30 through nonlinear medium 10, the second pass beams following beam path 32 through nonlinear medium 10, or the third pass beams following beam path 34 through nonlinear medium 10.

Phasor 16' has the same characteristics as phasor 16 in Figure 3.1. The first and second telescopes in apparatus 50 (formed by mirrors 18 and 20, and by mirrors 18' and 20', respectively) are both designed as indicated in the discussion of Figure 3.1 a, i.e., with A = D = -1 and C = 0 at the relevant phasor (i.e., phasor 16 for the telescope formed by mirrors 18 and 20, and phasor 16' for the telescope formed by mirrors 18' and 20'), and designed to re-image reference plane 12 onto itself with -1 magnification. This arrangement provides the advantages of beam parallelism on all four passes, and beam collinearity and astigmatism compensation by design, also as indicated above. In addition, phasor 16 applies the same relative phase shift between the first and second passes of the beams as it does between the third and fourth passes of the beams. Because the beam pattern for the four passes is highly symmetrical, the required phase shift between the first and second passes and between the third and fourth passes is the same. Therefore, phasor 16 can simultaneously provide the required phase shift between the first and second passes, as well as between the third and fourth passes, which is highly desirable compared to an alternative where three independent phasors are used in four pass SHG. Even if a linearly varying phase shift is imposed on the beams by nonlinear medium 10 (e.g. if face 10-1 is not exactly perpendicular to the beam axes), this variation is cancelled in double pass, and phasor 16 will still simultaneously provide the required phase shift between the first and second passes, as well as between the third and fourth passes.

Implicit in the above discussion is an assumption that the pump beam and second harmonic beam are collinear within nonlinear medium 10 on the first pass. This assumption is frequently applicable (e.g. for collinear QPM or collinear BPM with negligible beam walkoff). In some cases, such as birefringent phase-matching with nonzero beam walkoff, the pump and second harmonic beams are not collinear over the entire length of nonlinear medium 10. In other cases, such as non-collinear phase-matching, the pump and second harmonic beams are not parallel within nonlinear medium 10. For these cases, the apparatus and methods discussed above are also advantageous, since compensation methods analogous to the lateral offset compensation discussed above can be applied to ensure that the second pass "undoes" the divergence of the pump beam from the second harmonic beam caused by the first pass. Similarly, the fourth pass can "undo" the relative divergence of the two beams caused by the third pass, etc.

The advantageous phase adjustment provided by a wedged phasor can be obtained in embodiments of the invention which do not include an inverting telescope

By combining a DECSL laser configuration with the particular, above-indicated periodically poled nonlinear optical materials of the present invention, a highly controllable, high reliability laser can be built which satisfies the reliability and optical performance needs of biophotonics applications. Moreover, the laser design of the current invention provides high wavelength stability and the lowest possible intensity noise of any solid-state laser design, given that the external cavity on the pump laser acts as a low-pass noise filter for the semiconductor material, and that the SHG process does not cause an increase in the noise.

Figure 4 shows a comparison of results achieved with a DECSL architecture, in accordance with the present invention, using gray track resistant PPKTP which demonstrates the lower noise when compared to either an OPSL and an Argon ion laser. Note the 50% improvement of the DESCL compared to the OPSL.

This noise reduction has been demonstrated to improve image quality in confocal microscopy applications. The image taken using the DESCL laser did not require Kalman averaging of a number of frames, so that the images could be taken directly. The image obtained using a DECSEL laser without Kalman filtering is comparable to images obtained with substantial filtering using an Argon ion or OPSL laser. The lower intensity noise of the DECSL has also been shown to produce lower coefficients of variation (CV) in cytometry applications. Using a laser in accordance with the present invention decreases in cytometry CVs of up to a factor of two to ten, depending primarily on the optical design of the flow system, have been observed. For clinical diagnostics, this difference in CV translates into significantly reduced rates of both false positives and false negatives, which significantly improves the clinical accu racy of a test.

The foregoing detailed description of the invention includes passages that are chiefly or exclusively concerned with particular parts or aspects of the invention. It is to be understood that this is for clarity and convenience, that a particular feature may be relevant in more than just the passage in which it is disclosed, and that the disclosure herein includes all the appropriate combinations of information found in the different passages. Similarly, although the various figures and descriptions herein relate to specific embodiments of the invention, it is to be understood that where a specific feature is disclosed in the context of a particular figure or embodiment, such feature can also be used, to the extent appropriate, in the context of another figure or embodiment, in combination with another feature, or in the invention in general.

Further, while the present invention has been particularly described in terms of certain preferred embodiments, the invention is not limited to such preferred embodiments. Rather, the scope of the invention is defined by the appended claims.

## Claims

1. A doubled, external cavity laser comprising an external cavity pump laser section and an extra-cavity frequency doubling section, said pump laser section comprising an edge-emitting, semiconductor chip having:

   i) an anti-reflection coating on the chip facet facing the cavity
   ii) a low reflectivity coating on the output facet of the cavity,
   iii) a wavelength selective element on the anti-reflection side of said chip for producing a single-mode output beam,
   iv) at least one lens on the output side of said chip which lens operates to collimate the chip output beam and direct said chip output beam to the frequency doubling section, which doubling section comprises:
   v) a second harmonic generating crystal of a material selected from the group consisting essentially of gray track resistant PPKTP, stoichiometric PPLT, MgO doped stoichiometric PPLN, and MgO doped congruent PPLN,
   vi) doubling optics configured such that the chip output beam makes from one up to four collinear passes through the doubling crystal, and the second harmonic generation achieved through multiple passes is constructive,

   vi) beam shaping optics to create a collimated, frequency doubled output beam.

**2.** A laser in accordance with Claim 1 wherein said crystal material is MgO doped stoichiometric PPLN or MgO doped congruent PPLN.

**3.** A laser in accordance with Claim 2 wherein said crystal material is MgO doped congruent PPLN.

**4.** A laser in accordance with either Claim 2 or Claim 3 wherein said crystal material is stoichiometric PPLT.

**5.** A laser in accordance with either Claim 2 or Claim 3 wherein said crystal material is grey track resistant PPKTP.

**6.** A laser in accordance with any one of the preceding claims wherein said frequency doubled output beam has a wavelength of substantially 488nm.

**7.** A laser in accordance with any one of the preceding claims wherein said frequency doubled output beam has a wavelength of substantially 505nm.

**8.** A laser in accordance with any one of the preceding claims wherein said frequency doubled output beam has a wavelength between 528nm and 532nm.

**9.** A laser in accordance with any one of the preceding claims wherein said frequency doubled output beam has a wavelength between 350nm and 360nm.

**10.** A laser in accordance with any one of the preceding claims wherein said doubling optics cause said chip output beam to make two or four collinear passes through said doubling crystal.

**11.** A laser in accordance with any one of the preceding claims wherein said beam shaping optics comprise a collimation lens, an anamorphic prism pair and a tilted focusing lens.

**12.** A laser in accordance with any one of the preceding claims wherein said doubling optics comprise a phasor and at least two mirrors.

**13.** A laser in accordance with Claim 12 wherein said mirrors act as an inverting telescope.

**14.** A laser in accordance with any one of the preceding claims wherein the faces of said frequency doubling crystal are anti-reflection coated.

**15.** A laser according to any one of the preceding claims operably connected to provide the light source to a biomedical instrument selected from the group consisting of flow cytometers, DNA sequencers, RNA sequencers and confocal microscopes.

**FIGURE 1**

PRIOR ART

**FIGURE 2**

## FIGURES 3.1 and 3.2

### 3.1 Double-pass configuration

(a)                                                    (b)

### 3.2 Four-pass configuration

(a)

(b)

**FIGURE 4**